# EUROPÄISCHE PATENTSCHRIFT

(11) **EP 3 813 254 B1**
(45) Veröffentlichungstag und Bekanntmachung des Hinweises auf die Patenterteilung: **23.08.2023**
(21) Anmeldenummer: 20000378.8
(22) Anmeldetag: 20.10.2020
(51) Int. Cl.: H03F 1/32, H03F 3/183, H03F 3/45

(54) **VERSTÄRKERSCHALTUNG MIT VARIABLER STROMQUELLE**
AMPLIFIER CIRCUIT WITH VARIABLE CURRENT SOURCE
CIRCUIT AMPLIFICATEUR À SOURCE D'ALIMENTATION VARIABLE

(30) Priorität: 22.10.2019 DE 102019128498
(43) Veröffentlichungstag der Anmeldung: 28.04.2021
(73) Patentinhaber: Avantgarde Acoustic, 64686 Lautertal - Reichenbach (DE)
(72) Erfinder: Ruff, Matthias, 68307 Mannheim (DE)
(74) Vertreter: Lahni, Alexander

(56) Entgegenhaltungen:
- EP-A1- 0 032 533
- WO-A2-03/090343
- DE-A1-102006 012 601
- JP-A- H07 212 145
- US-A1- 2002 039 049

## Beschreibung

Die Erfindung betrifft eine Verstärkerschaltung zum Betreiben eines Lautsprechers, umfassend zwei Eintaktverstärkerschaltungen, die jeweils einen Eingang und einen Ausgang sowie ein Verstärkerelement und eine Konstantstromquelle aufweisen, wobei vorgesehen ist, dass an mindestens einem Eingang ein Wechselspannungssignale angelegt wird, dass der Lautsprecher zwischen den Ausgängen angeordnet wird. Ferner betrifft die Erfindung einen Audioverstärker mit einer solchen Verstärkerschaltung.

Verstärkerschaltungen zum Betreiben von Lautsprechern sind weithin bekannt. Ein allgemeines Ziel bei der Konstruktion solcher Schaltungen ist es, dass das am Lautsprecher anliegende, verstärkte Signal das Eingangssignal möglichst genau abbildet. Die Eingangssignale sind dabei üblicherweise sehr kleinschrittig linearisierte Signale, die etwa Abtastraten von 44,1 bis 192 kHz nutzen, um Audiosignale im hörbaren Frequenzbereich etwa zwischen 20 und 20.000 Hz abzubilden. Üblicherweise kann das Eingangssignal jedoch nur angenähert genau abgebildet werden, so dass das Ausgangssignal unerwünschten Verzerrungen unterworfen ist. Ein weiteres Problem ist, dass die Impedanz von Lautsprechern über den hörbaren Frequenzbereich variiert, die Ausgangsspannung an einem Verstärker diese Varianz jedoch nicht abbilden kann, was ebenfalls zu Verzerrungen führt.

Gängige Verstärkerschaltungen sind etwa als Eintaktverstärker bekannt, die im Class A Betrieb betreibbar sind und dabei einen Ruhestrom benötigen, der zu einer hohen Verlustleistung führt. Alternativ können Gegentaktverstärker zum Einsatz kommen, die auch im Class B oder Class AB Betrieb nutzbar sind und dann eine geringere Verlustleistung aufweisen. Um das Ausgangssignal derartiger Verstärkerschaltungen zu verbessern, kommen üblicherweise Gegenkopplungen zum Einsatz, bei denen das verstärkte Signal auf den Eingang zurückgekoppelt wird. Solche Gegenkopplungen sind jedoch auf Grund von Laufzeitunterschieden zu dem am Eingang anliegenden Signal anfällig für sogenannte TIM-Verzerrungen, die sich nicht harmonisch zum Signal verhalten und somit von einem Hörer als störend empfunden werden. Auch sind Brückenschaltungen von Verstärkern bekannt, die genutzt werden, um Verzerrungen zu reduzieren.

Aus US 2005/0134374 A1 ist ein Audioverstärker bekannt, der frequenzabhängig als Spannungs- oder als Stromverstärker funktioniert, indem die Ausgangsimpedanz des Verstärkers frequenzabhängig in einem weiten Bereich verändert wird. Um eine solche Schaltung zu realisieren, sind sowohl spannungs- als auch stromgetriebene Gegenkopplungen vorgesehen, wobei in einem hörbaren Frequenzbereich die Stromgegenkopplung dominiert, während in einem höheren Frequenzbereich die Spannungsgegenkopplung dominiert. Nachteilig können die Gegenkopplungen zu unerwünschten TIM-Verzerrungen führen. Weiterhin ist eine solche Verstärkerschaltung nicht für einen Brückenbetrieb geeignet, da der Messwiderstand für die Stromgegenkopplung an Masse liegen muss.

Aus GB 2526630 ist weiterhin ein Stromverstärker mit einer Howlandschaltung zur Versorgung einer Induktionsspule, die ein Audiosignal an einzelne Kopfhörer bzw. Hörgeräte überträgt, bekannt. Um Instabilitäten, insbesondere bei Schaltungen für große Induktionsspulen zu vermeiden, werden die aus der Howlandschaltung bekannten Widerstandswerte verändert, was zu einem Leistungsabfall bei höheren Frequenzen führt. Ein solcher Leistungsabfall disqualifiziert die Schaltung für den Einsatz bei hochwertigen Audioverstärkern.

Aus der DE 10 2006 012 601 A1 ist eine eingangs genannte Verstärkerschaltung bekannt.

Aus EP 0 032 533 A1 ist eine Verstärkerschaltung mit bipolaren integrierten Halbleiterverstärkerstufen bekannt, bei der zwischen einer ersten Differenzverstärkerstufe und einer daran angeschlossenen zweiten Verstärkerstufe eine temperaturabhängige Gegenkopplungsschaltung vorgesehen ist, deren Temperaturgang den des Wandlers über dem gesamten Betriebstemperaturbereich praktisch genau kompensiert.

Ausgehend von dem genannten Stand der Technik ist es eine Aufgabe der Erfindung, für eine Verstärkerschaltung der gattungsgemäßen Art eine verbesserte oder zumindest eine alternative Ausführungsform bereitzustellen, wobei insbesondere für den Betrieb von hocheffizienten Hornlautsprechern auf den Einsatz von Gegenkopplungen verzichtet werden soll.

Diese Aufgabe wird erfindungsgemäß gelöst durch den Gegenstand der unabhängigen Ansprüche. Vorteilhafte Ausführungsformen der Erfindung sind in den Unteransprüchen angegeben.

Erfindungsgemäß steuern die Verstärkerelemente jeweils eine variable Stromquelle, so dass das eingehende Wechselspannungssignal in ein Stromsignal übersetzt wird, wobei an den Ausgängen ein Ausgangsstrom erzeugt wird.

Unter einem Lautsprecher wird hier ein Gerät zur Wiedergabe von Audiosignalen verstanden. Bei solchen Lautsprechern wird zumeist eine Membran durch ein elektromagnetisches Signal in Bewegung versetzt, so dass eine Luftbeschleunigung in Form einer Druckwelle erzeugt wird, die vom menschlichen Ohr als Schalldruck wahrnehmbar ist. Dem Fachmann sind vielfältige Ausführungen solcher Lautsprecher bekannt, so wie etwa Tauchspulenlautsprecher oder magnetostatische Lautsprecher. Eine erfindungsgemäße Verstärkerschaltung ist für alle bekannten Lautsprecher nutzbar. Ein besonderes Augenmerk liegt dabei auf hocheffizienten Hornlautsprechern, wobei die Vorteile der Erfindung insbesondere bei Hochtonlautsprecher zu Geltung kommen, die besonders hochfrequente Signale wiedergeben müssen.

Ein Verstärkerelement ist ein elektronisches Bauteil, welches ein auf einer eingangs anliegenden Spannung oder einem eingangs anliegenden Strom aufgeprägtes Signal auf eine größere ausgangsseitige Spannung oder einen größeren ausgangsseitigen Strom aufprägt. Übliche, dem Fachmann bekannte Bauformen, sind insbesondere Transistoren und Röhren. Transistoren sind in vielfältigen Bauformen bekannte, die hier alle unter dem Begriff Transistor verstanden werden sollen. Dies sind etwa Feldeffekttransistoren (beispielsweise MOSFET, JFET), IGBT Transistoren, Darlington Transistoren oder bipolare Transistoren. Unter dem Begriff Verstärkerelement sind hier auch Schaltungen aus mehreren einzelnen Verstärkerelementen zu verstehen. So kann ein Verstärkerelement beispielsweise zur Erzielung einer besonders großen Verstärkung aus mehreren Stufen von Transistoren bestehen.

Ein Wechselspannungssignal ist eine Wechselspannung, auf die eine Information aufgeprägt ist. So kann die Frequenz, mit der die Spannung zwischen dem positiven und dem negativen Spannungsbereich wechselt, der Frequenz eines Tones entsprechen, den ein Instrument während einer Audioaufnahme erzeugt hat. Das Wechselspannungssignal kann etwa ein mit einem Mikrophon aufgenommenes Audiosignal sein. Bei der Aufnahme von Audiosignalen mittels Mikrophonen erzeugt ein Schalldruck, der über die Luft vom Instrument zum Mikrophon übertragen wird, eine Auslenkung der Mikrofonmembran, die in einer gewissen Abtastrate gemessen und in ein linearisiertes Wechselspannungssignal übersetzt wird.

Eine Konstantstromquelle ist ein Bauteil, welches einen konstanten, das heißt einen höchstens in einem minimalen Toleranzbereich schwankenden Gleichstrom zur Verfügung stellt. Eine Ausführungsform einer solchen Konstantstromquelle ist eine einfache, an einer Versorgungsspannung angeschlossene Stromquelle. Eine weitere, im Folgenden im Detail beschriebene Ausführungsform, ist ein an der Masse anliegendes induktives Element wie etwa eine Spule.

Die variable Stromquelle ist eine Stromquelle, die abhängig von dem Signal, mit dem sie von dem Verstärkerelement angesteuert wird, einen variablen Strom bereitstellt. Dies kann etwa ein Wechselstrom sein der auf einen Gleichstrom aufmoduliert wird. Je nach Signal, dass der variablen Stromquelle durch das Verstärkerelement aufgeprägt wird, kann diese auch ein lediglich im positiven oder lediglich im negativen Bereich schwingendes bzw. variierendes Signal erzeugen.

Einer erfindungsgemäßen Schaltung liegt der Gedanke zugrunde, dass ein Ausgangsstrom zum Betreiben eines Lautsprechers gegenüber einer Spannung, wie sie bei der überwiegenden Mehrzahl von bekannten Audioverstärkern am Ausgang gesteuert wird, vorteilhaft zu einer verbesserten Abbildung des Eingangssignals am Lautsprecher führt. Die Kraft, die die Membran eines Lautsprechers auslenkt, entsteht durch den fließenden Strom und das anliegende Magnetfeld. Die bei bekannten Verstärkern am Lautsprecher anliegende Spannung erzeugt zwar einen solchen Strom, der dann die Auslenkung der Membran bewirkt, jedoch wird der Strom nicht direkt durch den Verstärker gesteuert. Dies führt dazu, dass der Strom dem Spannungssignal folgen muss, wobei dieser Prozess notwendigerweise Verzögerungen und somit Verzerrungen unterworfen ist. Durch die unmittelbare Steuerung des Stroms werden solche Verzögerungen bzw. Verzerrungen vermieden und es entsteht vorteilhaft eine sehr gute Abbildung des verstärkten Signals am Lautsprecher. Eine solche Abbildung des Signals führt zu einem voluminöseren, verzerrungsfreieren Klang des Lautsprechers, bei dem ein verbesserter Raumklang erzeugt werden kann. Bei der Widergabe des Audiosignals mit zwei Lautsprechern, wie sie im HiFi-Bereich üblich ist, wird der Klang dann weniger zweidimensional wahrgenommen und kann durch das menschliche Ohr nicht mehr ohne weiteres der Klangquelle zugeordnet werden.

Ein weiterer Vorteil besteht darin, dass der Verlauf der oft stark ausgeprägten Lautsprecherimpedanz über den Frequenzbereich, in dem der Lautsprecher betrieben wird, keinen bzw. nur noch einen geringen Einfluss auf das Signal hat. So kann diese Impedanz beispielsweise um eine ganze Größenordnung schwanken, was bei einem aus dem Stand der Technik bekannten Spannungssignal am Verstärkerausgang dazu führt, dass in Bereichen mit hoher Impedanz die Wiedergabe eines Geräuschs deutlich gedämpft ist. Die Ausgangsspannung eines bekannten Verstärkers kann lediglich auf einen Mittelwert der Lautsprecherimpedanz ausgelegt werden. Um auszugeichen, dass die Impedanz über einen Frequenzbereich variiert, ist es dann nötig, das Signal entsprechend zu manipulieren, etwa über entsprechende Equalizer. Bei einer erfindungsgemäßen Verstärkerschaltung hat die Lautsprecherimpedanz nur einen geringen Effekt auf die Wiedergabe des Signals in einem bestimmten Frequenzbereich.

Die erfindungsgemäße Verstärkerschaltung weist einen Differenzverstärker auf, der auch bei einseitiger Ansteuerung beide variable Stromquellen mit einem symmetrischen Signal versorgt, wobei die Ausgangsstufen jeweils im Class A Betrieb betrieben werden. Es sind dann beide Verstärkerelemente an einer positiven Versorgungsspannung bzw. einer gemeinsamen an der positiven Versorgungsspannung liegenden Stromquelle angeschlossen, etwa, im Falle eines Transistors als Verstärkerelement mit dem emitterseitigen Anschluss dieses Transistors. In einer bevorzugten Ausführungsform wird der Differenzverstärker beidseitig angesteuert.

In einer bevorzugten Ausführungsform der Erfindung werden die Konstantstromquellen der beiden Ausgangsstufen durch induktive Elemente gebildet. Ein solches induktives Element hat gegenüber einer Stromquelle, die an einer Versorgungsspannung angeschlossen ist, den Vorteil einer deutlich geringeren Verlustleistung. Bevorzugt ist das induktive Element eine Spule, die besonders bevorzugt eine Kernspule ist, die an der Masse angeschlossen ist und durch ihre Induktivität einen konstanten Gleichstrom mit geringen Schwankungen liefern kann. Der Konstantstromquelle kommt in der Schaltung einer jeden Eintaktverstärkerschaltung die Funktion zu, das verstärkte Signal in einen positiven Bereich zu verschieben.

Nach einem Aspekt der Erfindung ist der Ausgang einer jeden Eintaktverstärkerschaltung zwischen der variablen Stromquelle und der Konstantstromquelle angeordnet. Die durch die variable Stromquelle und durch die Konstantstromquelle erzeugten Ströme addieren sich dann nach der Knotenregel zu einem Gesamtstrom, der dem Lautsprecher zufließt.

Die variable Stromquelle ist erfindungsgemäß durch einen Transistor mit einem Emitterwiderstand gebildet. Der Emitterwiderstand, der zwischen dem Transistor und einer negativen Versorgungsspannung liegt, liefert dabei abhängig von der Basisspannung einen Strom. Dabei ist die negative Versorgungsspannung konstant, so dass über die Basisspannung, der die Emitterspannung folgt, unmittelbar über den dadurch entstehenden Spannungsabfall am Widerstand ein Strom gesteuert werden kann. Eine solche Schaltung ist vorteilhaft, sehr einfach und stabil.

Bevorzugt ist der Emitterwiderstand niederohmig im Vergleich mit dem Lastwiderstand, hier also dem Lautsprecher, so dass die Verlustleistung an dem Emitterwiderstand gegenüber der Ausgangsleistung klein ist. Beispielsweise kann in einer Schaltung, in der der mittlere Widerstand des Lautsprechers 4 bis 8 Ω beträgt, der Emitterwiderstand kleiner 0.5 Ω sein.

In einer besonders bevorzugten Ausführungsform sind die Verstärkerelemente Transistoren, wie zum Beispiel Bipolartransistoren. Transistoren sind einfach auszuführen und verhalten sich stabil. Es ist ferner auch möglich, die Verstärkerelemente als Verstärkerröhren auszuführen.

Die Verstärkerelemente der einzelnen Eintaktverstärkerschaltungen sind bevorzugt als Differenzverstärker miteinander verschaltet. Falls es sich bei den Verstärkerelementen um Transistoren handelt, können etwa die Emittereingänge an einer positiven Versorgungsspannung bzw. einer gemeinsamen, an einer positiven Versorgungsspannung angeschlossenen, Stromquelle angeschlossen sein, so dass der von der Stromquelle erzeugt Strom sich immer auf die beiden Verstärkerelemente aufteilt. Vorteilhaft lässt sich so eine besonders gute Verstärkung realisieren.

Besonders bevorzugt sind die Konstantstromquellen der Ausgangsstufen durch Kernspulen gebildet, deren Kerne miteinander gekoppelt sind. Die durch Konstantströme in den beiden Kernspulen induzierten Magnetfelder wirken dann gegeneinander und die Kerne werden magnetisch nicht gesättigt. Dennoch können die Kernspulen jeweils für die Wechselströme der variablen Stromquelle eine hohe Induktivität zur Verfügung stellen, um die Konstantströme mit möglichst geringen Schwankungen konstant zu halten. Mit gekoppelten Kernen können die Kernspulen sowohl hinsichtlich Kerngröße als auch hinsichtlich Wicklungszahl und Leiterdurchmesser klein gestaltet werden. Dabei sind die Kernspulen derart ausgelegt, dass sich die durch einen Konstantstrom durch die Kernspulen induzierten Magnetfelder gegenseitig im Wesentlichen auslöschen.

In einer Ausgestaltung dieser Ausführungsform sind die Kerne der beiden Spulen durch einen Luftspalt voneinander beabstandet. Durch einen solchen Luftspalt wird eine Vormagnetisierung der Kerne erreicht. Es kommt dann durch nicht zu vermeidende, geringfüge Schwankungen in den Konstantströmen, die etwa im Bereich von wenigen mA liegen, nicht zu Ummagnetisierungen der Kerne, die zu Hystereseeffekten im Bereich eines Nulldurchgangs führen würde.

Für einen solcher Luftspalt kann weiterhin bevorzugt eine Einrichtung zum Einstellen vorgesehen sein. Das Verhalten der Kernspulen bzw. der Kerne kann dann auf die Gesamtschaltung bzw. auf einen angeschlossenen Lautsprecher angepasst werden, so dass ein ideales Klangverhalten an jeder Art von Lautsprecher und bei jeder Lautsprecherimpedanz zu erreichen bzw. einstellbar ist.

Von der Impedanz eines Lautsprechers und insbesondere von dem Frequenzbereich, in dem der Lautsprecher arbeiten soll, hängt es weiterhin ab, welche Induktivität ein induktives Element als Konstantstromquelle aufweisen muss. So können für Hochtöner etwa Kernspulen mit 2 mH ausreichen, während bei tieferen Frequenzen Induktivitäten im Bereich von 150 mH bevorzugt werden. Die Induktivität ist so zu wählen, dass sie ausreicht, um bei den anliegenden Lasten einen stabilen Konstantstrom zu erzeugen.

Besonders bevorzugt und bereits im vorhergehenden Beschreibungstext referenziert, gleichen sich die Eintaktverstärkerschaltungen. Eine so zu erreichende vollständige Symmetrie führt dazu, dass der Lautsprecher besonders verzerrungsarm betrieben werden kann.

Ein erfindungsgemäßer Audioverstärker ist zumindest mit einer solchen Verstärkerschaltung ausgebildet, die mit den vorangehend beschriebenen Merkmalen ausgestaltet ist.

Weitere Merkmale und Vorteile der Erfindung ergeben sich aus den Unteransprüchen, aus den Zeichnungen und aus der zugehörigen Figurenbeschreibung anhand der Zeichnungen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungsbeispiele der Erfindung sind in den Zeichnungen dargestellt und werden in der nachfolgenden Beschreibung näher erläutert, wobei sich gleiche Bezugszeichen auf gleiche oder ähnliche oder funktional gleiche Bauteile beziehen. Hierbei zeigt:
- Figur 1:: einen Schaltplan einer erfindungsgemäßen Verstärkerschaltung;
- Figur 2:: einen Schaltplan einer aus dem Stand der Technik bekannten Verstärkerschaltung, bei der eine Ausgangsspannung gesteuert wird;
- Figur 3:: einen Ersatzschaltbild eines realen Lautsprechers, der im Folgenden zu Simulationszwecken verwendet wird;
- Figur 4:: ein beispielhaftes Eingangssignal, dass durch eine erfindungsgemäße Verstärkerschaltung verstärkt werden kann;
- Figur 5:: die bei einer aus dem Stand der Technik bekannten Verstärkerschaltung an einem Lautsprecher anliegenden Strom- und Spannungsverläufe in Relation zu einem Eingangssignal;
- Figur 6:: die bei einer erfindungsgemäßen Verstärkerschaltung an einem Lautsprecher anliegenden Strom- und Spannungsverläufe in Relation zu einem Eingangssignal.

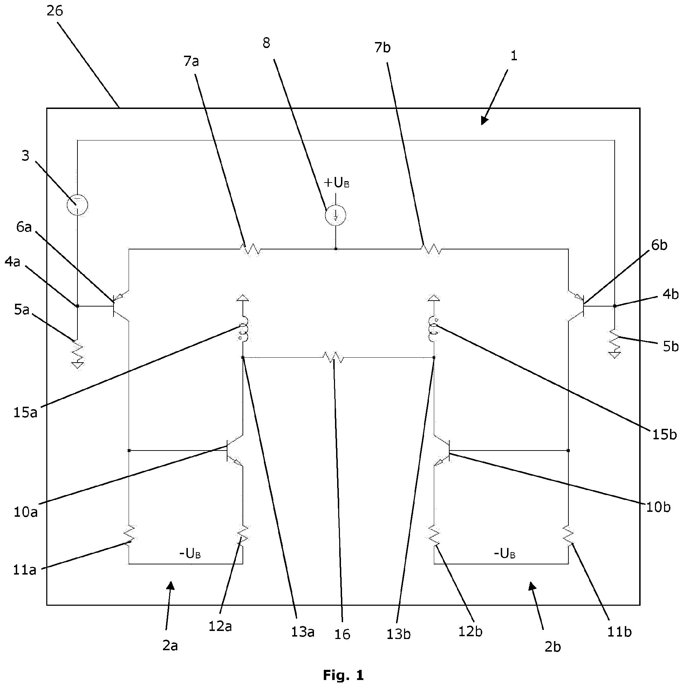

Figur 1 zeigt einen Schaltplan einer erfindungsgemäßen Verstärkerschaltung 1, die eine erste Eintaktverstärkerschaltung 2a und eine zweite Eintaktverstärkerschaltung 2b aufweist. Von einer Spannungsquelle 3 werden die Eingänge 4a, 4b der Eintaktverstärkerschaltungen 2a, 2b mit zueinander invertierten Eingangssignalen bespielt, wobei die Eingänge 4a, 4b jeweils über Eingangswiderstände 5a, 5b an Masse anliegen. Unmittelbar hinter den Eingängen 4a, 4b sind Verstärkerelemente 6a, 6b in Form von pnp-Bipolartransistoren angeordnet, wobei die Eingänge 4a, 4b mit den Basisklemmen der Verstärkerelemente 6a, 6b verbunden sind, so dass die Eingangsspannung steuert, wie durchlässig der jeweilige Transistor auf der Kollektor-Emitter-Strecke ist. Die Emitter der Verstärkerelemente 6a, 6b sind jeweils über hochohmige Widerstände 7a, 7b mit der gleichen Stromquelle 8 verbundene, die an einer positiven Versorgungsspannung, beispielsweise von 12 oder 24 V, anliegt. Über den Anschluss der Emitterklemmen an die gemeinsame Stromquelle 8 wird ein Differenzverstärker realisiert, bei dem die Differenz zwischen den an den Eingängen 4a und 4b anliegenden Spannungssignalen verstärkt wird.

Die Verstärkerelemente 6a, 6b sind kollektorseitig an die Basen weiterer npn-Transistoren angeschlossen, die als variable Stromquellen 10a, 10b fungiert, sowie über weitere Widerstände 11a, 11b an eine negative Versorgungsspannung, die beispielsweise -24 V betragen kann. Die variablen Stromquellen 10a, 10b werden durch Transistoren realisiert, bei denen an der Emitterklemme jeweils ein Emitterwiderstand 12a bzw. 12b angeordnet ist, der an der negativen Versorgungsspannung angeschlossen ist. Über die an den Emitterwiderständen 12a, 12b anliegenden Spannungen lässt sich der jeweils durch den Transistor und somit auch der an Ausgängen 13a, 13b anliegende Strom steuern. Die Emitterwiderstände 12a, 12b sind dafür bevorzugt niederohmig, etwa in einem Bereich um 0,5 Ω.

An den Ausgängen 13a, 13b liegt weiterhin der Strom von Konstantstromquellen 15a, 15b an, die hier als Kernspulen ausgeführt sind und ihrerseits an Masse angeschlossen sind. Durch das Vorsehen der Konstantstromquellen 15a, 15b lässt sich der ausgangsseitige Strom in einen positiven Bereich verschieben. Zwischen den Ausgängen 13a, 13b ist ein Lautsprecher 16 anordnenbar, der hier durch einen einfachen Widerstand dargestellt ist. Es kann sich etwa um einen Lautsprecher 16 mit einer mittleren Impedanz von 8 Ω handeln.

Figur 1 ist ferner schematisch ein erfindungsgemäßer Audioverstärker 26 zu entnehmen, der zumindest eine Verstärkerschaltung 1, wie im Schaltplan ersichtlich, umfasst.

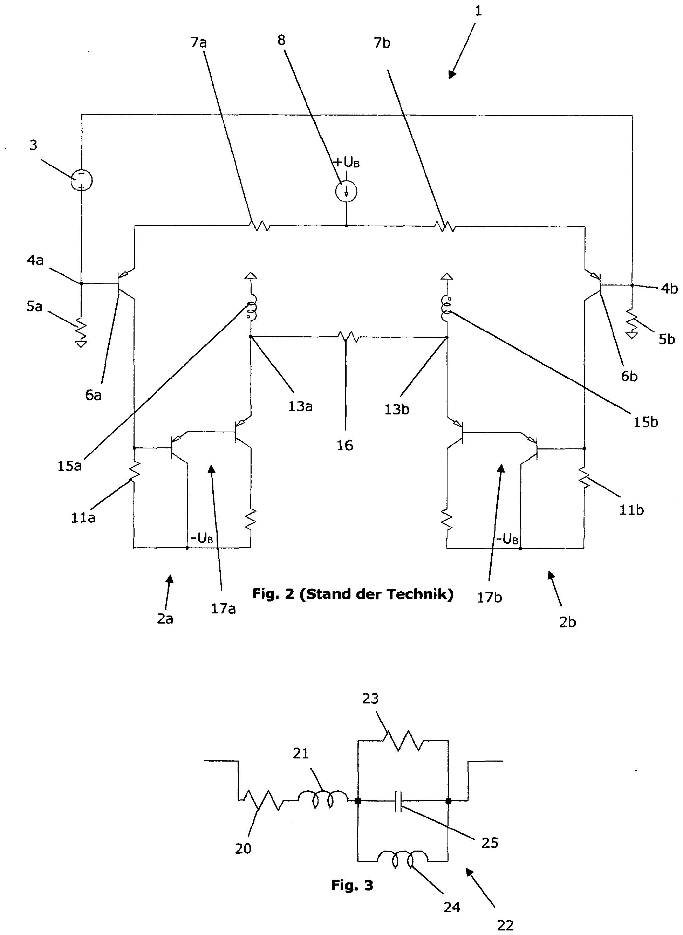

Figur 2 zeigt eine aus dem Stand der Technik bekannte Spannungsverstärkerschaltung, der sich von der in Figur 1 gezeigten Verstärkerschaltung darin unterscheidet, dass die Verstärkerelemente 6a, 6b keine variable Stromquelle 10a, 10b steuern, sondern jeweils eine variable Spannungsquelle 17a, 17b, die durch eine zweistufige Kaskade aus pnp-Transistoren realisiert ist, deren Kollektoren jeweils an der negativen Versorgungsspannung angeschlossen sind.

Im Folgenden wird anhand von Simulationsergebnissen, die mit den oben gezeigten Schaltungen simuliert wurden, der Unterscheid zwischen einer bekannten Spannungsverstärkerschaltung gemäß Figur 2 und einer erfindungsgemäßen Verstärkerschaltung diskutiert. Dafür wird bei der Simulation statt eines einfachen Widerstands wie in den oberen Schaltplänen eine Ersatzschaltung als Lautsprecher 16 verwendet, die das reale Verhalten des Lautsprechers 16 besser abbildet. So kann ein tatsächlich an einem Lautsprecher 16 anliegendes Signal besser nachvollzogen werden. Figur 3 zeigt diese Ersatzschaltung eines realen Lautsprechers 16, mit der im Folgenden zum Zwecke der Simulation die in den Figuren 1 und 2 verwendeten einfachen ohmschen Lasten ersetzt werden. Die Ersatzschaltung weist einen ohmschen Widerstand 20 sowie eine Induktivität 21 der Schwingspule und einen Schwingkreis 22, der die mechanischen Eigenschaften des Lautsprechers abbildet auf. Der Schwingkreis 22 weist seinerseits einen weiteren Widerstand 23 für die mechanischen Verluste des Lautsprechers, eine Induktivität 24 für die Federwirkung des Systems und einer Kapazität 25 zur Darstellung der Massenträgheit der Membran und der Schwingspule auf.

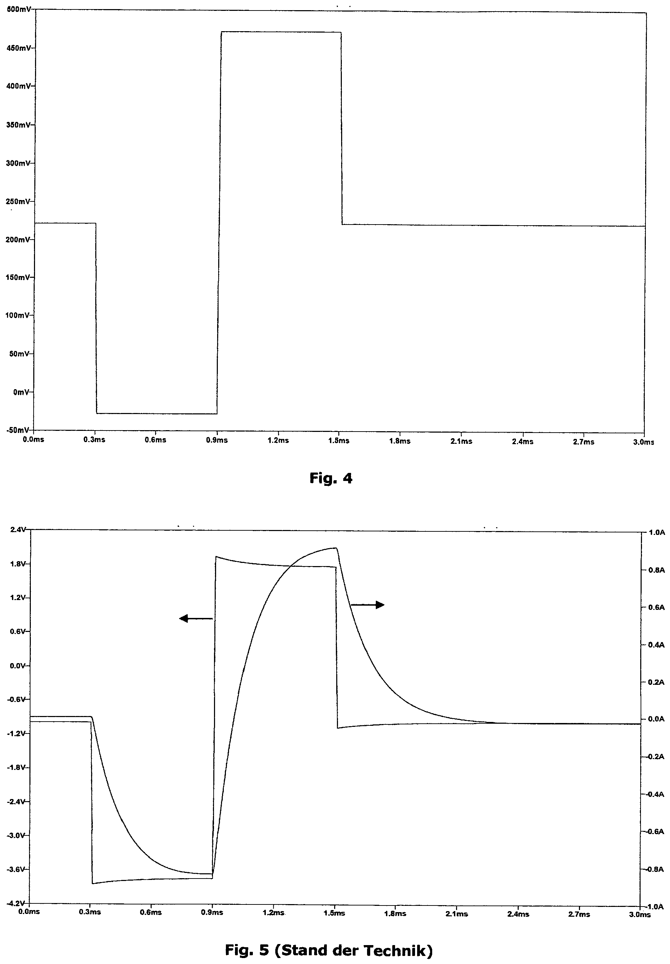

In Figur 4 ist ein beispielhaftes Eingangssignal, welches durch eine Spannungsquelle 3 erzeugt wird, gezeigt. Dabei wurde ein Eingangssignal gewählt, welches mehrere Spannungssprünge mit steilen Flanken aufweist, und zwar bei 0,3, bei 0,9 und bei 1,5 ms. Das dargestellte Eingangssignal wurde in Simulationen verwendet, um die durch verschiedene Verstärkerschaltungen an Lautsprechern angelegten Signale zu simulieren.

Figur 5 zeigt in einem Diagramm die an dem Lautsprecher 16 anliegenden Spannungs- und Stromverläufe in einer aus dem Stand der Technik bekannten Spannungsverstärkerschaltung gemäß Figur 2 mit einem Lautsprecher 16 gemäß Figur 3. Die Pfeile zeigen dabei an, welcher Graph welcher y-Achse zugeordnet ist. Im Vergleich mit dem in Figur 4 gezeigten Eingangssignal ist zu erkennen, dass der am Lautsprecher 16 anliegende Spannungsverlauf das Eingangssigna im Verlauf gut abbildet, wobei das Spannungsniveau durch die Verstärkung zwischen ca. -3,8 V und +1,8 V liegt. Der Stromverlauf, der der Spannungsverlauf folgt und zwischen -0,9 und +0,9 A liegt, entspricht dem Eingangssignal jedoch nicht mehr, da jeder Spannungssprung erst verzögert zu einem entsprechenden Stromniveau führt. Der Stromverlauf kann den stielen Flanken des Spannungsverlaufs nicht folgen. Ein solcher Stromverlauf führt zu einer verzerrten Abbildung des Eingangssignals am Lautsprecher 16.

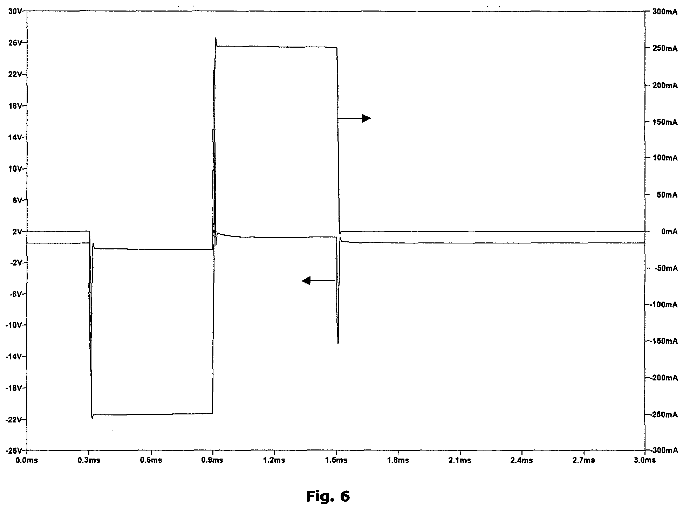

Figur 6 zeigt entsprechende Verläufe der Spannung und des Stroms am Lautsprecher 16 bei einer erfindungsgemäßen Verstärkerschaltung gemäß Figur 1 mit dem in Figur 4 gezeigten Eingangssignal, wobei wiederum die Pfeile die Zuordnung der Graphen zu den Y-Achsen angeben. Hier wird der Strom gesteuert, so dass die Abbildung des Eingangssignals im Strom in einem Bereich zwischen ca. -250 bis ca. +250 mA sehr gut ist, während die Spannung dem Strom folgt. Dies hat zur Folge, dass bei Stufen im Eingangssignal sehr große Spannungspeaks bis -17 und +22 V am Lautsprecher erzeugt werden. Durch die genaue Abbildung des Eingangssignals im Ausgangsstrom bzw. dem am Lautsprecher anliegenden Strom wird ein weniger verzerrter und als räumlicher wahrnehmbarerer Klang als bei einer Schaltung gemäß Figur 2 an dem Lautsprecher 16 erzeugt.

### Bezugszeichen

- 1: Verstärkerschaltung
- 2a: Eintaktverstärkerschaltung
- 2b: Eintaktverstärkerschaltung
- 3: Spannungsquelle
- 4a: Eingang
- 4b: Eingang
- 5a: Eingangswiderstand
- 5b: Eingangswiderstand
- 6a: Verstärkerelement
- 6b: Verstärkerelement
- 7a: Widerstand
- 7b: Widerstand
- 8: Stromquelle
- 10a: variable Stromquelle
- 10b: variable Stromquelle
- 11a: Widerstand
- 11b: Widerstand
- 12a: Emitterwiderstand
- 12b: Emitterwiderstand
- 13a: Ausgang
- 13b: Ausgang
- 15a: Konstantstromquelle
- 15b: Konstantstromquelle
- 16: Lautsprecher
- 17a: variable Spannungsquelle
- 17b: variable Spannungsquelle
- 20: ohmscher Widerstand
- 21: Induktivität
- 22: Schwingkreis
- 23: Widerstand
- 24: Induktivität
- 25: Kapazität
- 26: Audioverstärker

## Patentansprüche

1. Verstärkerschaltung (1) zum Betreiben eines Lautsprechers (16), umfassend zwei Eintaktverstärkerschaltungen (2a, 2b), die jeweils einen Eingang (4a, 4b) und einen Ausgang (13a, 13b) sowie ein Verstärkerelement (6a, 6b) und eine Konstantstromquelle (15a, 15b) aufweisen, wobei die Konstantstromquellen (15a, 15b) der beiden Eintaktverstärkerschaltungen (2a, 2b) durch Kernspulen gebildet sind, deren Kerne miteinander gekoppelt sind, wobei die Kernspulen derart ausgelegt sind, dass sich die durch einen Konstantstrom durch die Kernspulen induzierten Magnetfelder gegenseitig im Wesentlichen auslöschen, und wobei vorgesehen ist, dass an mindestens einem Eingang (4a, 4b) ein Wechselspannungssignal angelegt wird, und dass der Lautsprecher (16) zwischen den Ausgängen (13a, 13b) angeordnet wird,
**dadurch gekennzeichnet, dass** die Verstärkerelemente (6a, 6b) jeweils eine variable Stromquelle (10a, 10b) steuern, so dass das eingehende Wechselspannungssignal in ein Stromsignal übersetzt wird, wobei die variable Stromquelle (10a, 10b) jeweils durch einen Transistor mit einem Emitterwiderstand (12a, 12b) gebildet ist und, dass die Ausgänge (13a, 13b) der Eintaktverstärkerschaltungen (2a, 2b) jeweils zwischen variabler Stromquelle (10a, 10b) und Konstantstromquelle (15a, 15b) angeordnet sind, wobei in dem an den Ausgängen (13a, 13b) angeschlossenen Lautsprecher (16) ein Ausgangsstrom erzeugt wird, und wobei der Ausgangsstrom jeweils die Summe aus den Strömen der variablen Stromquelle (10a, 10b) und der Konstantstromquelle (15a, 15b) ist.

2. Verstärkerschaltung (1) nach Anspruch 1,
**dadurch gekennzeichnet, dass** mindestens eine Konstantstromquelle (15a, 15b) durch ein induktives Element gebildet ist.

3. Verstärkerschaltung (1) nach Anspruch 1 oder 2,
**dadurch gekennzeichnet, dass** vorgesehen ist, dass an den Eingängen (4a, 4b) der Eintaktverstärkerschaltungen (2a, 2b) zueinander invertierte Wechselspannungssignale angelegt werden.

4. Verstärkerschaltung (1) nach einem der vorhergehenden Ansprüche,
**dadurch gekennzeichnet, dass** der Emitterwiderstand (12a, 12b) niederohmig ist.

5. Verstärkerschaltung (1) nach einem der vorhergehenden Ansprüche,
**dadurch gekennzeichnet, dass** die Verstärkerelemente (6a, 6b) Transistoren sind.

6. Verstärkerschaltung (1) nach einem der vorhergehenden Ansprüche,
**dadurch gekennzeichnet, dass** die Verstärkerelemente (6a, 6b) als Differenzverstärker miteinander verschaltet sind.

7. Verstärkerschaltung (1) nach einem der vorhergehenden Ansprüche,
**dadurch gekennzeichnet, dass** die Kerne der beiden Kernspulen durch einen Luftspalt voneinander beabstandet sind.

8. Verstärkerschaltung (1) nach Anspruch 7,
**dadurch gekennzeichnet, dass** eine Einrichtung zum Einstellen des Luftspalts vorgesehen ist.

9. Verstärkerschaltung (1) nach einem der vorhergehenden Ansprüche,
**dadurch gekennzeichnet, dass** die Konstantstromquellen (15a, 15b) durch induktive Elemente gebildet sind, die mindestens eine Induktivität von 2 mH aufweisen.

10. Verstärkerschaltung (1) nach einem der vorhergehenden Ansprüche,
**dadurch gekennzeichnet, dass** die beiden Eintaktverstärkerschaltungen (2a, 2b) sich gleichen.

11. Audioverstärker (26),
**dadurch gekennzeichnet, dass** der Audioverstärker (26) mindestens eine Verstärkerschaltung (1) umfasst, die nach einem der Ansprüche 1 bis 10 ausgebildet ist.

## Claims

1. Amplifier circuit (1) for operating a loudspeaker (16), comprising two single-ended amplifier circuits (2a, 2b) each having an input (4a, 4b) and an output (13a, 13b) as well as an amplifier element (6a, 6b) and a constant current source (15a, 15b), wherein the constant current sources (15a, 15b) of the two single-ended amplifier circuits (2a, 2b) are formed by core coils, the cores of which are coupled to one another, wherein the core coils are designed in such a manner that the magnetic fields induced by a constant current through the core coils substantially cancel one another out, and wherein provision is made for an AC voltage signal to be applied to at least one input (4a, 4b) and for the loudspeaker (16) to be arranged between the outputs (13a, 13b),
**characterized in that** the amplifier elements (6a, 6b) each control a variable current source (10a, 10b), with the result that the incoming AC voltage signal is converted into a current signal, wherein the variable current source (10a, 10b) is respectively formed by a transistor with an emitter resistor (12a, 12b), and **in that** the outputs (13a, 13b) of the single-ended amplifier circuits (2a, 2b) are each arranged between the variable current source (10a, 10b) and the constant current source (15a, 15b), wherein an output current is generated in the loudspeaker (16) connected to the outputs (13a, 13b), and wherein the output current is respectively the sum of the currents from the variable current source (10a, 10b) and the constant current source (15a, 15b).

2. Amplifier circuit (1) according to Claim 1, **characterized in that** at least one constant current source (15a, 15b) is formed by an inductive element.

3. Amplifier circuit (1) according to Claim 1 or 2, **characterized in that** provision is made for AC voltage signals which are inverted with respect to one another to be applied to the inputs (4a, 4b) of the single-ended amplifier circuits (2a, 2b).

4. Amplifier circuit (1) according to one of the preceding claims,
**characterized in that** the emitter resistor (12a, 12b) has a low resistance.

5. Amplifier circuit (1) according to one of the preceding claims,
**characterized in that** the amplifier elements (6a, 6b) are transistors.

6. Amplifier circuit (1) according to one of the preceding claims,
**characterized in that** the amplifier elements (6a, 6b) are connected to one another as differential amplifiers.

7. Amplifier circuit (1) according to one of the preceding claims,
**characterized in that** the cores of the two core coils are spaced apart from one another by an air gap.

8. Amplifier circuit (1) according to Claim 7,
**characterized in that** a device for adjusting the air gap is provided.

9. Amplifier circuit (1) according to one of the preceding claims,
**characterized in that** the constant current sources (15a, 15b) are formed by inductive elements which have at least an inductance of 2 mH.

10. Amplifier circuit (1) according to one of the preceding claims,
**characterized in that** the two single-ended amplifier circuits (2a, 2b) are the same.

11. Audio amplifier (26),
**characterized in that** the audio amplifier (26) comprises at least one amplifier circuit (1) which is designed according to one of Claims 1 to 10.

## Revendications

1. Circuit amplificateur (1) permettant de faire fonctionner un haut-parleur (16), comprenant deux circuits amplificateurs à simple alternance (2a, 2b) qui présentent respectivement une entrée (4a, 4b) et une sortie (13a, 13b) ainsi qu'un élément d'amplificateur (6a, 6b) et une source de courant constant (15a, 15b), dans lequel les sources de courant constant (15a, 15b) des deux circuits amplificateurs à simple alternance (2a, 2b) sont formées par des bobines de noyau dont les noyaux sont couplés les uns aux autres, dans lequel les bobines de noyau sont conçues de telle sorte que les champs magnétiques induits par un courant constant à travers les bobines de noyau se neutralisent substantiellement mutuellement, et dans lequel il est prévu qu'un signal de tension alternative soit appliqué à au moins une entrée (4a, 4b), et que le haut-parleur (16) soit disposé entre les sorties (13a, 13b),
**caractérisé en ce que** les éléments d'amplificateur (6a, 6b) commandent respectivement une source de courant variable (10a, 10b) de telle sorte que le signal de tension alternative entrant est converti en un signal de courant, dans lequel la source de courant variable (10a, 10b) est formée respectivement par un transistor muni d'une résistance d'émetteur (12a, 12b), et **en ce que** les sorties (13a, 13b) des circuits amplificateurs à simple alternance (2a, 2b) sont disposées respectivement entre la source de courant variable (10a, 10b) et la source de courant constant (15a, 15b), dans lequel un courant de sortie est généré dans le haut-parleur (16) connecté aux sorties (13a, 13b), et dans lequel le courant de sortie est respectivement la somme des courants de la source de courant variable (10a, 10b) et de la source de courant constant (15a, 15b) .

2. Circuit amplificateur (1) selon la revendication 1, **caractérisé en ce qu'**au moins une source de courant constant (15a, 15b) est formée par un élément inductif.

3. Circuit amplificateur (1) selon la revendication 1 ou 2, **caractérisé en ce qu'**il est prévu que des signaux de tension alternative mutuellement inversés soient appliqués aux entrées (4a, 4b) des circuits amplificateurs à simple alternance (2a, 2b).

4. Circuit amplificateur (1) selon l'une quelconque des revendications précédentes, **caractérisé en ce que** la résistance d'émetteur (12a, 12b) est à basse impédance.

5. Circuit amplificateur (1) selon l'une quelconque des revendications précédentes, **caractérisé en ce que** les éléments d'amplificateur (6a, 6b) sont des transistors.

6. Circuit amplificateur (1) selon l'une quelconque des revendications précédentes, **caractérisé en ce que** les éléments d'amplificateur (6a, 6b) sont connectés ensemble sous forme d'amplificateurs différentiels.

7. Circuit amplificateur (1) selon l'une quelconque des revendications précédentes, **caractérisé en ce que** les noyaux des deux bobines de noyau sont espacés l'un de l'autre par un entrefer.

8. Circuit amplificateur (1) selon la revendication 7, **caractérisé en ce qu'**un dispositif de réglage de l'entrefer est prévu.

9. Circuit amplificateur (1) selon l'une quelconque des revendications précédentes, **caractérisé en ce que** les sources de courant constant (15a, 15b) sont formées par des éléments inductifs qui présentent au moins une inductance de 2 mH.

10. Circuit amplificateur (1) selon l'une quelconque des revendications précédentes, **caractérisé en ce que** les deux circuits amplificateurs à simple alternance (2a, 2b) sont similaires.

11. Amplificateur audio (26), **caractérisé en ce que** l'amplificateur audio (26) comprend au moins un circuit amplificateur (1) qui est réalisé selon l'une quelconque des revendications 1 à 10.
